# EUROPÄISCHE PATENTSCHRIFT

(11) **EP 3 217 428 B1**
(45) Veröffentlichungstag und Bekanntmachung des Hinweises auf die Patenterteilung: **07.09.2022**
(21) Anmeldenummer: 16158942.9
(22) Anmeldetag: 07.03.2016
(51) Int. Cl.: H01L 23/544, H01L 23/12, H01L 23/373, H05K 1/02

(54) **MEHRFACHSUBSTRAT SOWIE VERFAHREN ZU DESSEN HERSTELLUNG**
MULTIPLE SUBSTRATE AND METHOD FOR THE PRODUCTION OF SAME
SUBSTRAT MULTIPLE ET SON PROCÉDÉ DE PRODUCTION

(43) Veröffentlichungstag der Anmeldung: 13.09.2017
(73) Patentinhaber: Infineon Technologies AG, 85579 Neubiberg (DE)
(72) Erfinder: Roth, Alexander, 93197 Zeitlarn (DE)
(74) Vertreter: Dilg, Haeusler, Schindelmann Patentanwaltsgesellschaft mbH

(56) Entgegenhaltungen:
- DE-U1- 9 310 299
- US-A- 5 676 855
- US-A1- 2008 164 588
- US-A1- 2013 313 711

## Beschreibung

Die vorliegende Erfindung betrifft ein Mehrfachsubstrat nach Anspruch 1 sowie ein Verfahren zur Herstellung eines Mehrfachsubstrats nach Anspruch 6.

Bekannt ist es, Substrate, insbesondere auch solche mit einer Isolier- oder Trägerschicht aus Keramik, beispielsweise Aluminium-Oxid-Keramik, im Mehrfachnutzen, das heißt als Mehrfachsubstrat mit einer Vielzahl von Einzelsubstraten auf der gemeinsamen Isolier- und Trägerschicht herzustellen und auch mit elektronischen Bauelementen zu bestücken, wobei das Mehrfachsubstrat dann für die weitere Verwendung in die Einzelsubstrate zertrennt bzw. vereinzelt wird. Dieses Vereinzeln erfolgt insbesondere bei Mehrfachsubstraten mit einer Isolier- und Trägerschicht aus Keramik durch Schneiden, insbesondere mittels Laser, entlang von die Einzelsubstrate begrenzende Schnittlinien und/oder durch Brechen entlang der Schnitt- bzw. Sollbruchlinien.

Derartige Mehrfachsubstrate sind beispielsweise in der DE 195 04 378 A1, der DE 44 44 680 A1 und der DE 93 10 299 U1 beschrieben.

Die vorstehend genannten Keramiksubstrate werden zum Herstellen von elektrischen Schaltkreisen, insbesondere Leistungsschaltkreisen, verwendet und sind gewöhnlich an wenigstens einer Oberflächenseite mit einer Metallisierung versehen, die unter Anwendung einer Ätztechnik derart strukturiert wird, dass sie die für den Schaltkreis erforderlichen Leiterbahnen, Kontaktflächen und dergleichen bildet.

Für eine rationelle Fertigung der elektrischen Schaltkreise ist es bekannt, die Herstellung dieser Schaltkreise im Mehrfachnutzen vorzunehmen, das heißt insbesondere die Strukturierung der Metallflächen zur Erzielung der notwendigen Leiterbahnen, Kontaktflächen und dergleichen, aber auch die Bestückung mit den elektronischen Bauelementen an dem Mehrfachnutzen vorzunehmen, der dann nach der Fertigstellung der Strukturierung bzw. Bestückung in die jeweiligen Einzelsubstrate getrennt wird. Hierbei gehen jedoch Informationen das Einzelsubstrat betreffend verloren, zum Beispiel die Position des Einzelsubstrats in dem Mehrfachnutzen, der Hersteller des Einzelsubstrats, die Revisionsnummer des Layouts und dergleichen, da diese Informationen gewöhnlich lediglich in einem Randbereich des Mehrfachnutzens bzw. Mehrfachsubstrats hinterlegt sind.

Aus der DE 40 04 844 C1 ist es bekannt, Löcher in einer Metallisierung eines Keramiksubstrats vorzusehen, welche durch Ätzen hergestellt werden, um große Druck- und Zugspannungsunterschiede zwischen dem Keramiksubstrat und der auf diesem aufgebrachten Metallisierung zu vermeiden.

In ähnlicher Weise offenbart die DE 43 18 241 A1 , in einem Randbereich einer auf einer isolierenden Schicht flächig befestigten Metallschicht eine stellenweise Schwächung herbeizuführen, indem entlang dieses Randbereichs in die Metallschicht zwei Reihen von Öffnungen eingebracht werden.

US 2013/313711 A1 offenbart ein Einzelsubstrat mit einer Keramikplatte oder Keramikschicht und wenigstens einer an wenigstens einer an wenigstens einer Oberflächenseite der Keramikschicht flächig befestigten Metallschicht, wobei das Einzelsubstrat an wenigstens einem Randbereich wenigstens eine Versenkung aufweist, um mittels der wenigstens einen Versenkung im Randbereich eine Information zu kodieren.

DE 93 10 299 U1 offenbart ein Mehrfach-Substrat mit einer Keramikschicht, die wenigstens zwei aneinander anschließende und einstückig miteinander verbundene Nutzen bildet, welche jeweils an wenigstens einer Oberflächenseite der Keramikschicht mit wenigstens einer Metallisierung oder Metallfläche versehen sind, wobei die wenigstens zwei Nutzen über wenigstens eine in der Keramikschicht vorgesehenen Sollbruchlinie aneinander anschließen.

US 5 676 855 A offenbart ein Verfahren zum Herstellen eines metallbeschichteten Substrats. Das Substrat ist mit mindestens einer Isolierschicht und mindestens einer Metallschicht versehen, die an mindestens einer Seite der Isolierschicht angebracht ist. Die Metallschicht hat stellenweise Ausnehmungen in einem Randbereich.

Vor diesem Hintergrund liegt der vorliegenden Erfindung die Aufgabe zugrunde, ein verbessertes Substrat aufzuzeigen, auf dem bestimmte Informationen, insbesondere über dessen Herstellung, auf einfache Weise beständig und wenigstens maschinenlesbar gespeichert werden können. Insbesondere soll das Speichern der Informationen auf dem Substrat auch während der ohnehin an dem Substrat auszuführenden Bearbeitungsschritte, zum Beispiel während der Strukturierung einer auf wenigstens einer Oberflächenseite des Substrats flächig aufgebrachten Metallschicht, erfolgen können, um den Aufwand zur Speicherung der Informationen möglichst gering zu halten. Außerdem soll ein Mehrfachsubstrat mit diesen Eigenschaften aufgezeigt werden. Ferner soll ein Verfahren zur Herstellung des Substrats angegeben werden.

Diese Aufgabe wird durch ein Mehrfachsubstrat mit den Merkmalen des Anspruchs 1, sowie durch ein Verfahren mit den Merkmalen des Anspruchs 6 gelöst. Weitere, besonders vorteilhafte Ausgestaltungen der Erfindung offenbaren die jeweiligen Unteransprüche.

Es ist darauf hinzuweisen, dass die in der nachfolgenden Beschreibung einzeln aufgeführten Merkmale in beliebiger, technisch sinnvoller Weise miteinander kombiniert werden können Es ist ferner darauf hinzuweisen, dass die nachfolgend beschriebene Erfindung auf jede Art von Substrat angewendet werden kann, zum Beispiel AIN (Aluminiumnitrid), Si3N4(Siliziumnitrid), Al2O3(Aluminiumoxid) und dergleichen, die mit einer Metallschicht, zum Beispiel Cu (Kupfer) oder Al (Aluminium), beschichtet sind. Hierbei kann die Metallisierung durch unterschiedliche Verfahren auf wenigstens eine Oberflächenseite des Substrats aufgebracht sein, zum Beispiel durch AMB (Active Metal Brazing), DCB (Direct Copper Bonding), DAB (Direct Aluminum Bonding), Dickschichtverfahren und dergleichen. Besonders bevorzugt werden hierbei DCB- und AMB-Keramik-Substrate. Hierin nachstehend wird der Begriff Substrat" als Synonym für alle zuvor genannten Substratarten verwendet. Erfindungsgemäß weist ein Mehrfachsubstrat eine Keramikplatte oder Keramikschicht und wenigstens eine an wenigstens einer Oberflächenseite der Keramikschicht flächig befestigte Metallschicht auf. Die Metallschicht weist an wenigstens einem Randbereich wenigstens eine Versenkung auf. Hierunter ist zu verstehen, dass die Versenkung im Vergleich zu Oberflächenunebenheiten zum Beispiel aufgrund der Oberflächenrauigkeit der Metallschicht eine deutliche und im Wesentlichen bezüglich ihres Rands scharf begrenzte Vertiefung in der Metallschicht darstellt. Beispielsweise kann die Versenkung in die Metallschicht als lochförmige Vertiefung eingebracht sein, die sich hinsichtlich ihrer Tiefe deutlich von der umgebenden Oberfläche der Metallschicht abgrenzt.

Bevorzugt wird die wenigstens eine Versenkung in die Metallschicht durch Ätzen eingebracht. Dies kann in besonders vorteilhafter Weise gleichzeitig mit der ohnehin auszuführenden Strukturierung der Metallschicht einhergehen, so dass kein zusätzlicher Schritt zum Einbringen der Versenkung in die Metallschicht auf dem Substrat notwendig ist. Beim Dickschichtverfahren zum Aufbringen der Metallisierung auf wenigstens eine Oberflächenseite des Substrats geschieht dieses bevorzugt durch Rakeln.

Erfindungsgemäß kodiert die wenigstens eine Versenkung im Randbereich der Metallschicht eine Information. Das heißt, durch die vorherbestimmte und nicht willkürliche Anordnung der wenigstens einen Versenkung im Randbereich der Metallschicht lässt sich eine gewünschte, zu kodierende Information eindeutig in diesem Randbereich abbilden. Anders ausgedrückt wird mit Hilfe der wenigstens einen Versenkung eine Information beständig in der Metallschicht gespeichert, wie beispielsweise die Position oder eine laufende Nummer des Substrats auf einem Mehrfachsubstrat, eine Herstellerkennung des Substrats oder eine Revisionsnummer des Strukturierungslayouts des Substrats und dergleichen. Andere Informationen können auf diese Weise selbstverständlich ebenfalls auf dem Substrat gespeichert werden, zum Beispiel ein Datumscode der Belichtung des Substrats durch eine Filmmaske oder durch eine Laser-Direktbelichtung, eine beliebige, das Substrat identifizierende Losnummer oder eine Materialnummer und dergleichen.

Die erfindungsgemäße Informationsspeicherung in der Metallschicht des Substrats ermöglicht während aller Herstellungsschritte beim Substrathersteller, zum Beispiel in Form eines Mehrfachsubstrats, als auch später beim Nutzer des Substrats, zum Beispiel in Form von Einzelsubstraten, eine genaue Nachverfolgung. Ein weiterer Vorteil bei der Verwendung der Versenkung in der Metallschicht ist, dass die hierdurch in der Metallschicht gespeicherte Information maschinenlesbar ist und die Erfassung dieser Information vollkommen automatisiert erfolgen kann.

Gemäß einer vorteilhaften Ausgestaltung der Erfindung ist die Information in der Metallschicht mittels der wenigstens einen Versenkung binärkodiert, positionskodiert oder quaternär kodiert.

Bei der Binärkodierung entspricht das Vorhandensein einer Versenkung an einer bestimmten Position im Randbereich der Metallschicht einer logischen "1" und eine an der Position nicht vorhandene Versenkung entspricht einer logischen "0". Um eine Startposition und/oder Stoppposition eines Binärkodes anzuzeigen, können entsprechende zusätzliche Versenkungen am Anfang oder Ende des Binärkodes verwendet werden.

Alternativ kann die Information, zum Beispiel eine Zahl, unter Verwendung einer Positionskodierung in der Metallschicht gespeichert werden. Hierbei entspricht eine bestimmte Position der Versenkung entlang des Randbereichs der Metallschicht einer entsprechenden Zahl, wobei beispielsweise ein Abstand von 1 mm entlang des Metallrands eine Erhöhung/Verringerung der entsprechenden Zahl um 1 bedeuten kann. Der besondere Vorteil der Positionskodierung ist, dass sich die zu kodierende Information mit lediglich einer in die Metallschicht einzubringenden Versenkung speichern lässt.

In dem Fall, dass mehrere Versenkungen in zwei Reihen entlang des Randbereichs der Metallschicht angeordnet werden können, kann jede Position entlang des Metallrands zwei Versenkungen zur Kodierung der Information umfassen, womit sich vier Zustände pro Position kodieren lassen (quaternäre Kodierung). Hierdurch lässt sich eine hohe Informationsdichte erzielen.

Abhängig von der mittels der Versenkung zu speichernden Information und den durch die Versenkung neben ihrer Informationsdarstellung zusätzlich bereitgestellten Wirkung, zum Beispiel die eingangs erläuterten Eigenschaften einer Versenkung zur Verringerung der thermischen Wechselbeanspruchung, kann es gemäß einer weiteren Ausgestaltung der Erfindung vorteilhaft sein, dass die Information mittels der wenigstens einen Versenkung negativ kodiert ist. Mit anderen Worten kann das Fehlen einer Versenkung an einer bestimmten Position im Randbereich der Metallschicht dann eine logische "1" repräsentieren und eine vorhandene Versenkung eine logische "0". Bei der Positionskodierung zum Beispiel entspricht eine nicht vorhandene Versenkung der zu kodierenden Information, wobei die Vielzahl der vorhandenen Versenkungen im negativen Positionskode dann zusätzlich zur Verringerung der thermischen Wechselbeanspruchung verwendet werden können.

Die Erfindung sieht vor, dass die Versenkung die Dicke der Metallschicht vollständig durchdringt. Mit anderen Worten verläuft die Versenkung in der Metallschicht von ihrer der Substratoberfläche abgewandten Oberseite bis hin zur Substratoberfläche, auf die die Metallschicht aufgebracht ist. Hierdurch lässt sich in vorteilhafter Weise der optische Kontrast beim Lesen der mittels der Versenkung gespeicherten Information erhöhen.

Die wenigstens eine Versenkung kann sowohl auf der Oberseite des Substrats, sofern dort eine Metallschicht aufgebracht ist, als auch auf der Unterseite des Substrats, sofern dort eine Metallschicht aufgebracht ist, angeordnet sein.

Eine weitere vorteilhafte Ausgestaltung der Erfindung sieht vor, dass sich die Versenkung zu einem Randbereich der Keramikschicht hin öffnet, der dem Randbereich der Metallschicht zugewandt ist, in dem die wenigstens eine Versenkung angeordnet ist. Bevorzugt wird die Versenkung hierbei als Einkerbung in die Metallschicht eingebracht. Zwar beansprucht die auf diese Weise hergestellte Versenkung geringfügig mehr Platz als die in die Metallschicht geätzte Versenkung, jedoch bietet die sich zum Substratrand hin öffnende Versenkung den wesentlichen Vorteil, dass diese auch in einer Seitenansicht des Substrats erfasst, das heißt gelesen werden kann. So kann die durch die wenigstens eine Versenkung kodierte Information auch dann erfasst werden, wenn mehrere Substrate in einem Stapel übereinandergeschichtet sind.

Gemäß einer noch weiteren vorteilhaften Ausgestaltung der Erfindung weist die Metallschicht ferner einen Ausrichtungsindikator auf, der eine eindeutige Ausrichtung des Substrats ermöglicht. Insbesondere in dem Fall, dass mehrere Informationen entlang verschiedener Randbereiche der Metallschicht kodiert sind, ist eine zuverlässige und eindeutige Ausrichtung des Substrats vor dem Lesen der gespeicherten Information unerlässlich. Dies wird mit Hilfe des in die Metallschicht zum Beispiel durch Ätzen eingebrachten Ausrichtungsindikators ermöglicht.

Vorzugsweise kann der Ausrichtungsindikator zum Beispiel an einer Ecke der Metallschicht als dreieckförmige Aussparung in der Metallschicht ausgebildet sein.

Gemäß der vorliegenden Erfindung wird ein Mehrfachsubstrat mit einer Keramikplatte oder Keramikschicht bereitgestellt, die wenigstens zwei aneinander anschließende und einstückig miteinander verbundene Einzelsubstrate bildet, die wiederum durch wenigstens eine zwischen den Einzelsubstraten verlaufende Schnittlinie voneinander abgegrenzt sind. Als Schnittlinie ist hierbei eine solche Linie zu verstehen, entlang welcher das Mehrfachsubstrat in einem späteren Vereinzelungsschritt geschnitten und/oder gebrochen wird, um die Einzelsubstrate voneinander zu trennen. Hierbei sind die Einzelsubstrate in vorteilhafter Weise jeweils nach einer der zuvor beschriebenen Ausgestaltungen ausgebildet. Die Vorteile und Wirkungen eines solchen Mehrfachsubstrats ergeben sich unmittelbar aus den bereits beschriebenen Vorteilen und Wirkungen des erfindungsgemäßen Einzelsubstrats und gelten somit analog auch für das erfindungsgemäße Mehrfachsubstrat.

Gemäß einem noch weiteren Aspekt der vorliegenden Erfindung wird ein Verfahren zur Herstellung eines Substrats nach Anspruch 6 offenbart.

Bevorzugt kann die wenigstens eine Metallschicht nach einem der vorangehend bereits aufgeführten Beschichtungsverfahren auf die Substratoberfläche aufgebracht und flächig mit dieser befestigt werden.

Das Einbringen der wenigstens einen Versenkung im Randbereich der Metallschicht erfolgt erfindungsgemäß derart vorherbestimmt und nicht willkürlich, dass mit Hilfe der bestimmten Anordnung der wenigstens einen Versenkung im Randbereich der Metallschicht eine gewünschte, zu kodierende Information eindeutig in diesem Randbereich abgebildet wird. Die Abbildung der Information mittels der wenigstens einen Versenkung kann hierbei beispielsweise binärkodiert, positionskodiert und/oder quaternär kodiert sein.

Bezüglich der übrigen Definitionen, Wirkungen und Vorteile im Zusammenhang mit dem hierin offenbarten Herstellungsverfahren des Substrats wird auf die vorangehende Beschreibung des erfindungsgemäßen Substrats verwiesen, die in analoger Weise auch für das Verfahren gelten soll.

Gemäß einer vorteilhaften Ausgestaltung des erfindungsgemäßen Verfahrens umfasst das Einbringen der wenigstens einen Versenkung in die Metallschicht einen Belichtungsschritt zur fototechnischen Strukturierung der Metallschicht, bei dem wenigstens die Anordnung der wenigstens einen Versenkung auf der Metallschicht mittels Laser-Direktbelichtung erfolgt. Im Gegensatz zur Belichtung mit Hilfe von statischen Filmmasken bietet die Laser-Direktbelichtung u. a. den wesentlichen Vorteil, dass wenigstens die Anordnung der wenigstens einen Versenkung auf der Metallschicht dynamisch erfolgen kann. Somit lassen sich von Substrat zu Substrat unterschiedliche, sich verändernde Informationen mittels der wenigstens einen Versenkung in die Metallschicht "schreiben", was erhebliche fertigungstechnische Vorteile bietet.

Das eigentliche Einbringen der Versenkung in die Metallschicht kann anschließend wie bereits vorangehend beschrieben durch herkömmliches Ätzen erfolgen.

Weitere Merkmale und Vorteile der Erfindung ergeben sich aus der folgenden Beschreibung eines nicht einschränkend zu verstehenden Ausführungsbeispiels der Erfindung, die im Folgenden unter Bezugnahme auf die Zeichnung näher erläutert werden. In dieser Zeichnung zeigt schematisch:

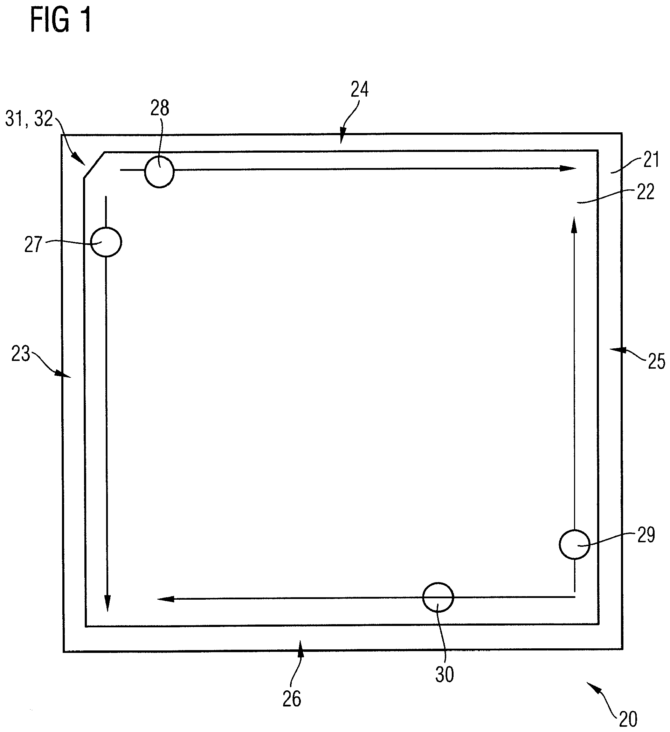

- Fig. 1: eine Draufsicht auf ein Ausführungsbeispiel eines Substrats gemäß der Erfindung.

Fig. 1 stellt eine Draufsicht auf ein Ausführungsbeispiel eines Substrats 20 gemäß der Erfindung dar. Das gezeigte Substrat 20 weist eine Keramikplatte oder Keramikschicht 21 auf und wenigstens eine an wenigstens einer Oberflächenseite der Keramikschicht 21 flächig befestigte Metallschicht 22. In

Fig. 1 ist die Oberseite des Substrats 20 dargestellt. Es ist zu verstehen, dass die in Fig. 1 nicht dargestellte Unterseite des Substrats 20 ebenfalls eine Metallschicht aufweisen kann.

Obwohl in Fig. 1 lediglich ein Substrat 20 dargestellt ist, ist zu verstehen, dass das Substrat 20 gemäß dieser Ausführungsform vor einer Vereinzelung Teil eines nicht dargestellten Mehrfachsubstrats rist, dessen Keramikschicht mehrere (Einzel-)Substrate 20 aneinander anschließend und einstückig miteinander verbunden bildet, die durch wenigstens eine zwischen den Einzelsubstraten 20 verlaufende Schnittlinie voneinander abgegrenzt sind. Entlang dieser Schnittlinien, die entlang der Ränder des Keramikschicht 21 des Substrats 20 verlaufen, können die Einzelsubstrate 20 zum Beispiel mittels Laser geschnitten und/oder gebrochen werden.

Das in Fig. 1 dargestellte Ausführungsbeispiel des Substrats 20 weist eine rechteckige, hier eine quadratische, Form auf. Die Metallschicht 22 umfasst vier Randbereiche 23, 24, 25 und 26. Wie Fig. 1 weiter zu entnehmen ist, ist je Randbereich 23, 24, 25 bzw. 26 jeweils eine Versenkung 27, 28, 29 bzw. 30 zu erkennen, die in die Metallschicht 22 eingebracht wurde. In jedem Randbereich 23, 24, 25 und 26 kodiert die in diesem jeweils angeordnete Versenkung 27, 28, 29 bzw. 30 jeweils eine Information das Substrat 20 betreffend. Mit anderen Worten sind bei dem in Fig. 1 gezeigten Ausführungsbeispiel des Substrats 20 insgesamt vier unterschiedliche Informationen in der auf der Oberseite des Substrats 20 angebrachten Metallschicht 22 gespeichert.

Die Versenkungen 27, 28, 29 und 30 sind bei dem Substrat 20 jeweils durch Ätzen in die Metallschicht 22 eingebracht worden. Insbesondere sind die in Fig. 1 dargestellten Versenkungen 27, 28, 29 und 30 vollständig durch die Metallschicht 22 geätzt worden, so dass der tiefste Punkte jeder Versenkung 27, 28, 29 und 30 jeweils bis zur Keramikschicht 21 (Substratoberfläche) reicht, um einen hohen optischen Kontrast für eine gute Erkennung der Versenkungen 27, 28, 29 und 30 zu erzielen.

Die im Randbereich 23 mittels der Versenkung 27 kodierte und gespeicherte Information stellt bei dem in Fig. 1 gezeigten Substrat 20 eine Reihenposition dar, die das Substrat 20 auf dem oben erwähnten Mehrfachsubstrat vor der Vereinzelung innehat. Im Randbereich 24 repräsentiert die Versenkung 28 eine entsprechend auf dem Mehrfachsubstrat eingenommene Spaltenposition des Substrats 20. Beide Informationen sind bei diesem Ausführungsbeispiel positionskodiert, das heißt die Position der jeweiligen Versenkung 27 bzw. 28 entlang der in Fig. 1 dargestellten Pfeilrichtung des entsprechenden Randbereichs 23 bzw. 24 ausgehend von einer oberen linken Ecke 31 der Metallschicht 22 repräsentiert die Reihenzahl bzw. Spaltenzahl des Substrats 20 im Mehrfachsubstrat, wobei bei dem dargestellten Ausführungsbeispiel des Substrats 20 ein Inkrement von 1 mm der entsprechenden Versenkung 27 bzw. 28 jeweils pro Reihe bzw. Spalte auf dem Mehrfachsubstrat festgelegt ist.

Im Randbereich 25 der Metallschicht 22 ist mittels der Versenkung 29 eine Revisionsnummer des auf der Metallschicht aufgebrachten Strukturierungslayouts (nicht dargestellt), zum Beispiel ein Datumscode einer Filmmaske, kodiert.

Im Randbereich 26 der Metallschicht 22 kodiert die Versenkung 30 eine Herstellerkennung des Substrats 20, wobei zum Beispiel eine Versenkung 30 einen ersten Hersteller repräsentiert, zwei im Randbereich 26 angeordnete Versenkungen 30 einen zweiten Hersteller usw.

Wie des Weiteren in Fig. 1 zu erkennen ist, ist die linke obere Ecke 31 der Metallschicht 22 als Ausrichtungsindikator 32 ausgebildet, der eine eindeutige Ausrichtung des Substrats 20 zur eindeutigen Erfassung der in den mehreren Randbereichen 23, 24, 25 und 26 der Metallschicht 22 kodierten Informationen ermöglicht. Auch dieser Ausrichtungsindikator 32 wird bevorzugt durch Ätzen in die Metallschicht eingebracht. Bei dem in Fig. 1 dargestellten Substrat 20 ist der Ausrichtungsindikator 32 in der Ecke 31 der Metallschicht 22 als dreieckförmige Aussparung ausgebildet. Andere geeignete (geometrische) Formen des Ausrichtungsindikators 32, die eine eindeutige Ausrichtung des Substrats 20 ermöglichen, sind denkbar.

Das vorstehend beschriebene erfindungsgemäße Mehrfachsubstrat sowie das Herstellungsverfahren sind nicht auf die hierin offenbarte Ausführungsform beschränkt, sondern umfassen auch gleich wirkende weitere Ausführungsformen, sofern diese unter den durch die Ansprüche definierten Schutzbereich fallen.

In bevorzugter Ausführung wird das erfindungsgemäße Mehrfachsubstrat, insbesondere Keramiksubstrat, mit einer auf wenigstens einer Oberflächenseite des Keramiksubstrats aufgebrachten Metallschicht, zum Beispiel Kupfer oder Aluminium, zur Herstellung von elektrischen Schaltkreisen, insbesondere Leistungsschaltkreisen, verwendet, wobei in der Metallschicht wenigstens eine Versenkung zur Kodierung einer Information eingebracht ist.

### Bezugszeichenliste:

- 20: Substrat
- 21: Keramikplatte oder Keramikschicht
- 22: Metallschicht
- 23: Randbereich
- 24: Randbereich
- 25: Randbereich
- 26: Randbereich
- 27: Versenkung
- 28: Versenkung
- 29: Versenkung
- 30: Versenkung
- 31: Ecke
- 32: Ausrichtungsindikator

## Patentansprüche

1. Mehrfachsubstrat mit einer Keramikplatte oder Keramikschicht (21) und wenigstens einer an wenigstens einer Oberflächenseite der Keramikschicht (21) flächig befestigten Metallschicht (22), wobei das Mehrfachsubstrat wenigstens zwei aneinander anschließende und einstückig miteinander verbundene Einzelsubstrate (20) bildet, die durch wenigstens eine zwischen den Einzelsubstraten (20) verlaufende Schnittlinie voneinander abgegrenzt sind, wobei die Einzelsubstrate (20) jeweils an wenigstens einem Randbereich (23, 24, 25, 26) wenigstens eine Versenkung (27, 28, 29, 30) aufweisen, sich die Einzelsubstrate (20) in der Position der Versenkung (27, 28, 29, 30) entlang des Randbereichs (23, 24, 25, 26) unterscheiden, um mittels der wenigstens einen Versenkung (27, 28, 29, 30) im Randbereich (23, 24, 25, 26) eine Information zu kodieren; wobei die Versenkung (27, 28, 29, 30) die Dicke der Metallschicht (22) vollständig durchdringt.

2. Mehrfachsubstrat nach Anspruch 1, wobei die Information mittels der wenigstens einen Versenkung (27, 28, 29, 30) negativ kodiert ist.

3. Mehrfachsubstrat nach einem der vorhergehenden Ansprüche, wobei sich die Versenkung (27, 28, 29, 30) zu einem Randbereich der Keramikschicht (21) hin öffnet, der dem Randbereich (23, 24, 25, 26) der Metallschicht (22) zugewandt ist, in dem die wenigstens eine Versenkung (27, 28, 29, 30) angeordnet ist.

4. Mehrfachsubstrat nach einem der vorhergehenden Ansprüche, wobei die Metallschicht (22) ferner einen Ausrichtungsindikator (31) aufweist, der eine eindeutige Ausrichtung des Substrats (20) ermöglicht.

5. Mehrfachsubstrat nach dem vorhergehenden Anspruch, wobei der Ausrichtungsindikator (32) an einer Ecke (31) der Metallschicht (22) als dreieckförmige Aussparung in der Metallschicht (22) ausgebildet ist.

6. Verfahren zur Herstellung eines Mehrfachsubstrats aufweisend wenigstens die Schritte:
- Ausbilden wenigstens zweier aneinander anschließender und einstückig miteinander verbundener Einzelsubstrate (20), die durch wenigstens eine zwischen den Einzelsubstraten (20) verlaufende Schnittlinie voneinander abgegrenzt sind, wobei das Ausbilden der Einzelsubstrate (20) jeweils wenigstens folgende Schritte aufweist:
- Bereitstellen einer Keramikplatte oder Keramikschicht (21),
- flächiges Befestigen wenigstens einer Metallschicht (22) an wenigstens einer Oberflächenseite der Keramikplatte oder Keramikschicht (21); Einbringen wenigstens einer Versenkung (27, 28, 29, 30) an wenigstens einem Randbereich (23, 24, 25, 26) der Metallschicht (22) pro Einzelsubstrat (20) derart, dass sich die Einzelsubstrate (20) in der Position der Versenkung (27, 28, 29, 30) entlang des Randbereichs (23, 24, 25, 26) unterscheiden, um mittels der wenigstens einen Versenkung (27, 28, 29, 30) im Randbereich (23, 24, 25, 26) eine Information zu kodieren, wobei die Versenkung (27, 28, 29, 30) die Dicke der Metallschicht (22) vollständig durchdringt.

7. Verfahren nach Anspruch 6,
wobei das Einbringen der wenigstens einen Versenkung (27, 28, 29, 30) in die Metallschicht (22) einen Belichtungsschritt zur fototechnischen Strukturierung der Metallschicht (22) umfasst, bei dem wenigstens die Anordnung der wenigstens einen Versenkung (27, 28, 29, 30) auf der Metallschicht (22) mittels Laser-Direktbelichtung erfolgt.

## Claims

1. A multiple substrate with a ceramic plate or ceramic layer (21) and at least one metal layer (22) fastened flat to at least one surface side of the ceramic layer (21), the multiple substrate forming at least two individual substrates (20) which adjoin one another and are integrally connected to one another and which are delimited from one another by at least one intersection line running between the individual substrates (20), wherein the individual substrates (20) each have at least one countersink (27, 28, 29, 30) at at least one edge region (23, 24, 25, 26), the individual substrates (20) differ in the position of the countersink (27, 28, 29, 30) along the edge region (23, 24, 25, 26) in order to encode information by means of the at least one countersink (27, 28, 29, 30) in the edge region (23, 24, 25, 26); wherein the countersink (27, 28, 29, 30) completely penetrates the thickness of the metal layer (22).

2. The multiple substrate of claim 1, wherein the information is negatively encoded by means of the at least one countersink (27, 28, 29, 30).

3. The multiple substrate according to any one of the preceding claims, wherein the countersink (27, 28, 29, 30) extends to an edge region of the ceramic layer (21), which faces the edge region (23, 24, 25, 26) of the metal layer (22) in which the at least one countersink (27, 28, 29, 30) is arranged.

4. The multiple substrate according to any one of the preceding claims, wherein the metal layer (22) further comprises an alignment indicator (31) that enables unambiguous alignment of the substrate (20).

5. The multiple substrate according to the preceding claim, wherein the alignment indicator (32) is formed at a corner (31) of the metal layer (22) as a triangular recess in the metal layer (22).

6. A method of manufacturing a multiple substrate comprising at least the steps of:
- Formation of at least two individual substrates (20) which adjoin one another and are integrally connected to one another and which are delimited from one another by at least one intersection line running between the individual substrates (20), wherein the formation of the individual substrates (20) each comprises at least the following steps:
- Providing a ceramic plate or ceramic layer (21);
- Flat attachment of at least one metal layer (22) to at least one surface side of the ceramic layer (21);
- introducing at least one countersink (27, 28, 29, 30) at at least one edge region (23, 24, 25, 26) of the metal layer (22) per individual substrate (20) such that the individual substrates (20) differ in the position of the countersink (27, 28, 29, 30) along the edge region (23, 24, 25, 26) in order to encode information by means of the at least one countersink (27, 28, 29, 30) in the edge region (23, 24, 25, 26), the countersink (27, 28, 29, 30) completely penetrating the thickness of the metal layer (22).

7. The Method according to claim 6,
wherein the introduction of the at least one countersink (27, 28, 29, 30) into the metal layer (22) comprises an exposure step for photo-technical structuring of the metal layer (22), in which at least the arrangement of the at least one countersink (27, 28, 29, 30) on the metal layer (22) is effected by means of laser direct exposure.

## Revendications

1. Substrat multiple avec une plaque de céramique ou une couche céramique (21) et au moins une couche métallique (22) fixée à plat sur au moins un côté de surface de la couche céramique (21), **caractérisé en ce que** le substrat multiple forme au moins deux substrats individuels (20) situés dans le prolongement l'un de l'autre et reliés l'un à l'autre d'un seul tenant, qui sont délimités l'un de l'autre par au moins une ligne de coupe s'étendant entre les substrats individuels (20), dans lequel les substrats individuels (20) présentent respectivement sur au moins une zone de bord (23, 24, 25, 26) au moins un renfoncement (27, 28, 29, 30), les substrats individuels (20) se distinguent dans la position du renfoncement (27, 28, 29, 30) le long de la zone de bord (23, 24, 25, 26) pour coder une information au moyen d'au moins un renfoncement (27, 28, 29, 30) dans la zone de bord (23, 24, 25, 26) ; dans lequel le renfoncement (27, 28, 29, 30) traverse totalement l'épaisseur de la couche métallique (22).

2. Substrat multiple selon la revendication 1, **caractérisé en ce que** l'information est codée de manière négative au moyen d'au moins un renfoncement (27, 28, 29, 30) .

3. Substrat multiple selon l'une quelconque des revendications précédentes, **caractérisé en ce que** le renfoncement (27, 28, 29, 30) s'ouvre en direction d'une zone de bord de la couche céramique (21), qui est tournée vers la zone de bord (23, 24, 25, 26) de la couche métallique (22), dans laquelle au moins un renfoncement (27, 28, 29, 30) est disposé.

4. Substrat multiple selon l'une quelconque des revendications précédentes, **caractérisé en ce que** la couche métallique (22) présente en outre un indicateur d'orientation (31), qui permet une orientation claire du substrat (20).

5. Substrat multiple selon la revendication précédente, **caractérisé en ce que** l'indicateur d'orientation (32) est réalisé sur un coin (31) de la couche métallique (22) en tant qu'évidement de forme triangulaire dans la couche métallique (22).

6. Procédé de fabrication d'un substrat multiple présentant au moins les étapes :
- de formation d'au moins deux substrats individuels (20) situés dans le prolongement l'un de l'autre et reliés l'un à l'autre d'un seul tenant, qui sont délimités l'un de l'autre par au moins une ligne de coupe s'étendant entre les substrats individuels (20), **caractérisé en ce que** la formation des substrats individuels (20) présente respectivement au moins des étapes suivantes :
- de fourniture d'une plaque en céramique ou d'une couche céramique (21),
- de fixation à plat d'au moins une couche métallique (22) sur au moins un côté de surface de la plaque en céramique ou de la couche céramique (21) ;
- de réalisation d'au moins un renfoncement (27, 28, 29, 30) sur au moins une zone de bord (23, 24, 25, 26) de la couche métallique (22) par substrat individuel (20) de telle manière que les substrats individuels (20) se distinguent dans la position du renfoncement (27, 28, 29, 30) le long de la zone de bord (23, 24, 25, 26) pour coder une information au moyen d'au moins un renfoncement (27, 28, 29, 30) dans la zone de bord (23, 24, 25, 26), dans lequel le renfoncement (27, 28, 29, 30) traverse totalement l'épaisseur de la couche métallique (22).

7. Procédé selon la revendication 6,
**caractérisé en ce que** la réalisation d'au moins un renfoncement (27, 28, 29, 30) dans la couche métallique (22) comprend une étape d'exposition lumineuse pour la structuration phototechnique de la couche métallique (22), où au moins l'agencement d'au moins un renfoncement (27, 28, 29, 30) sur la couche métallique (22) est effectué au moyen d'une exposition directe lumineuse laser.
